# EUROPÄISCHE PATENTSCHRIFT

(11) **EP 3 715 156 B1**
(45) Veröffentlichungstag und Bekanntmachung des Hinweises auf die Patenterteilung: **04.08.2021**
(21) Anmeldenummer: 19165027.4
(22) Anmeldetag: 25.03.2019
(51) Int. Cl.: B60H 1/00, B60H 1/32, H05K 7/20, H05K 5/02, B60K 1/00, B60H 1/14

(54) **FREQUENZUMRICHTERKÜHLUNG**
FREQUENCY CONVERTER COOLING
REFROIDISSEMENT DE CONVERTISSEUR DE FRÉQUENCE

(43) Veröffentlichungstag der Anmeldung: 30.09.2020
(73) Patentinhaber: Konvekta Aktiengesellschaft, 34613 Schwalmstadt-Ziegenhain (DE)
(72) Erfinder: Sonnekalb, Michael, 34613 Schwalmstadt (DE); Schneider, René, 34639 Schwarzenborn (DE)
(74) Vertreter: Lindinger, Bernhard

(56) Entgegenhaltungen:
- WO-A1-2012/081056
- WO-A1-2018/166935
- DE-A1-102014 109 051

## Beschreibung

### Gebiet der Technik:

Die Erfindung betrifft eine Heiz- und Klimaanlage für ein Fahrzeug, die zum Heizen im Wärmepumpenbetrieb und umschaltbar zum Kühlen im Klimabetrieb betreibbar ausgebildet ist, mit einem Kältemittelkreislauf umfassend wenigstens einen elektrisch betreibbaren in seiner Drehzahl über einen Frequenzumrichter/Inverter regelbaren Verdichter, einen Außenluftwärmetauscher, ein Expansionsorgan und einen Innenluftwärmetauscher. Diese Art von Heiz- und Klimaanlagen werden insbesondere in Omnibussen und Schienenfahrzeugen eingesetzt. Ferner betrifft die Erfindung eine Kühlplatte zum Kühlen des Frequenzumrichter/Inverter sowie ein Verfahren zum Regeln des Kühlens des Frequenzumrichters/Inverters beim Betrieb einer derartigen Heiz- und Klimaanlage. Ein Frequenzumrichter/Inverter regelt die Drehzahl des elektrisch betriebenen Verdichters frequenzvariabel und somit die Leistung des Verdichters. Damit kann die Leistungsaufnahme an den Kühlbedarf und im Falle eines Wärmepumpenbetriebes an den Heizbedarf angepasst möglichst gering gehalten werden. Jedoch kann der Frequenzumrichter/Inverter wie insbesondere dessen Leistungselektronik dabei zu heiß werden, sodass er gekühlt werden muss.

### Stand der Technik:

Der Frequenzumrichters/Inverters ist bisher oft Wasser- oder Luft gekühlt. Bei der Luftkühlung, wird ein Luftstrom über die Lamellen des Frequenzumrichters/Inverters geleitet, der die Wärmeenergie abführt. Eine weitere Variante ist die Abführung der Wärme per Konvektion von Luft. Bei der Wasserkühlung wird beispielweise ein Wasser-Glykol-Gemisch durch eine Kühlplatte des Frequenzumrichters/Inverters geleitet. Eine derartige Kühlplatte zum Durchströmen von Kühlflüssigkeit ist in DE 10 2004 055 815 A1 als Montageplatte offenbart. Darin ist eine wieder lösbare also reversible Montage eines Frequenzumrichters auf der Kühlplatte durch eine Befestigung mittels Nuten, Nutsteinen, Nuteinsätzen, Winkelblech, Halteleisten und leistenartigen Brücken beschrieben, wodurch Frequenzumrichter unterschiedlicher Baugröße auf der Kühlplatte montiert werden können.

Bekannt sind Klimaanlagen, bei denen das Kühlen des Frequenzumrichters/Inverters für das Regeln der Drehzahl des elektrisch betreibbaren Verdichters mit Hilfe des Kältemittels des Kältemittelkreislaufs der Klimaanlage erfolgt. Beispielsweise ist in DE 696 14 856 T2 ein Kältemittelkompressor als Verdichter mit einer elektronischen Schaltung als Frequenzumrichter/Inverter des Verdichters offenbart, bei der die elektronische Schaltung eine wärmeleitende Verbindung zu einer Kühlplatte hat, in der ein Kanal für als Sauggas strömendes Kältemittel gebildet ist. Dabei wird bei Betrieb des Kältemittelkreislaufs der Klimaanlage der Frequenzumrichter/Inverter mittels des kalten als Sauggas strömenden Kältemittels gekühlt. Zwar kann die elektronische Schaltung in DE 696 14 856 T2 auch das dort als Einspritzventil bezeichnete Expansionsorgan vor dem Verdampfer regeln, und damit die Überhitzung des vom Verdichter durch das Kühlsystem gesaugte Kältemittel regeln, aber dennoch bleibt das Kühlen des Frequenzumrichters nachteilig immer abhängig von der Temperatur und Strömungsdichte des als Sauggas durch die Kühlplatte strömenden Kältemittels sowie dadurch abhängig von der Leistung der Klimaanlage. Gerade im Wärmepumpenbetrieb einer Heiz- und Klimaanlage, also bei bereits geringer Außentemperatur, kann durch eine derartige Sauggaskühlung des Frequenzumrichter/Inverters dessen Temperatur zu niedrig werden. Die Temperatur der Leistungselektronik des Frequenzumrichters/Inverters darf nicht zu niedrig sein, denn bei zu geringer Temperatur arbeitet beispielsweise dessen Leistungselektronik unzureichend und es besteht zum Beispiel die Gefahr von Schäden an ihr durch Kondensat im Frequenzumrichter/Inverter wegen zu geringer Verdampfungstemperatur. Die in JP2006064357A offenbarte Heiz- und Klimaanlage für ein Fahrzeug ist zum Heizen im Wärmepumpenbetrieb und umschaltbar zum Kühlen im Klimabetrieb betreibbar ausgebildet. Ihr Kältemittelkreislauf umfasst wenigstens einen elektrisch betreibbaren in seiner Drehzahl über einen Frequenzumrichter/Inverter regelbaren Verdichter, einen Außenluftwärmetauscher, ein Expansionsorgan und einen Innenluftwärmetauscher. Dabei wird bei Betrieb der Frequenzumrichter/Inverter ebenfalls mittels des als Sauggas strömenden kalten Kältemittels gekühlt. Aber auch dort ist das Kühlen des Frequenzumrichters nachteilig immer abhängig von der Temperatur und Strömungsdichte des als Sauggas durch die Kühlplatte strömenden Kältemittels und dadurch abhängig von der Leistung der Heiz- und Klimaanlage. In WO 2018/166935 A1 ist eine Vorrichtung zum Kühlen eines Umrichters, die zum Heizen im Wärmepumpenbetrieb und umschaltbar zum Kühlen im Klimabetrieb betreibbar ausgebildet ist, mit einem Kältemittelkreislauf umfassend einen elektrisch betreibbaren Verdichter, einen Außenluftwärmetauscher, ein Expansionsventil und einen Innenluftwärmetauscher, derart ausgebildet, dass im Klimabetrieb der Außenluftwärmetauscher als Kondensator und der Innenluftwärmetauscher als Verdampfer und im Wärmepumpenbetrieb der Außenluftwärmetauscher als Verdampfer und der Innenluftwärmetauscher als Kondensator betreibbar sind, und der Verdichter in seiner Drehzahl über einen Umrichter regelbar ist, offenbart. Ferner ist dort ein Verfahren zum Kühlen eines Umrichters mit einer derartigen Vorrichtung offenbart. In dem dortigen Verfahren wird dafür das Expansionsventil gesteuert.

Der im Anspruch 1 angegebenen Erfindung liegt also die Aufgabe zugrunde, eine hinsichtlich des Kühlens des Frequenzumrichters/Inverters verbesserte Heiz- und Klimaanlage für ein Fahrzeug, die zum Heizen im Wärmepumpenbetrieb und umschaltbar zum Kühlen im Klimabetrieb betreibbar ausgebildet ist, mit einem Kältemittelkreislauf umfassend wenigstens einen elektrisch betreibbaren in seiner Drehzahl über einen Frequenzumrichter/Inverter regelbaren Verdichter, einen Außenluftwärmetauscher, ein Expansionsorgan und einen Innenluftwärmetauscher, bereitzustellen.

Eine entsprechende Aufgabe liegt bezüglich der Bereitstellung einer Kühlplatte zum Kühlen eines Frequenzumrichters/Inverters einer derartigen Heiz- und Klimaanlage zugrunde.

Eine entsprechende weitere Aufgabe liegt bezüglich der Bereitstellung eines Verfahrens zum Regeln des Kühlens des Frequenzumrichters/Inverters beim Betrieb einer derartigen Heiz- und Klimaanlage zugrunde.

### Zusammenfassung der Erfindung:

Die der im Anspruch 1 angegebenen Erfindung zugrundeliegende Aufgabe wird durch die im Anspruch 1 aufgeführten Merkmale gelöst. Die Aufgabe wird dadurch, dass die Heiz- und Klimaanlage für ein Fahrzeug, die zum Heizen im Wärmepumpenbetrieb und umschaltbar zum Kühlen im Klimabetrieb betreibbar ausgebildet ist, mit einem Kältemittelkreislauf umfassend wenigstens einen elektrisch betreibbaren Verdichter, einen Außenluftwärmetauscher, ein Expansionsorgan und einen Innenluftwärmetauscher, derart ausgebildet ist, dass im Klimabetrieb der Außenluftwärmetauscher als Kondensator/Gaskühler und der Innenluftwärmetauscher als Verdampfer und im Wärmepumpenbetrieb der Außenluftwärmetauscher als Verdampfer und der Innenluftwärmetauscher als Kondensator/Gaskühler betreibbar sind, und dass der Verdichter in seiner Drehzahl über einen Frequenzumrichter/Inverter regelbar ist, wobei der Frequenzumrichter/Inverter derart angeordnet ist, dass er bei zumindest einem Kältemittelleitungsverlauf im Klimabetrieb durch im Kältemittelkreislauf stromabwärts vom Innenluftwärmetauscher zum Verdichter als Sauggas strömendes Kältemittel über eine Wärmetauschverbindung zu über 70 % der Wärmeableitung vom Frequenzumrichter/Inverter kühlbar ist und bei zumindest einem Kältemittelleitungsverlauf, von dem einer seines im Wärmepumpenbetrieb wenigstens einen für als Sauggas strömendes Kältemittel angeordneten Kältemittelleitungsabschnitt vom Außenluftwärmetauscher zum Verdichter ohne Wärmetauschverbindung mit dem Frequenzumrichter/Inverter verläuft, im Wärmepumpenbetrieb zu über 70 % der Wärmeableitung vom Frequenzumrichter/Inverter mit Luft kühlbar ist, gelöst. Hinsichtlich der Kühlbarkeit des Frequenzumrichters/Inverters durch als Sauggas strömendes Kältemittel über eine Wärmetauschverbindung wird angemerkt, dass diese Art des Kühlens des Frequenzumrichters/Inverters dabei normalerweise nicht die alleinige ist, sondern normalerweise gleichzeitig mit ihr zusammen auch noch ein dazu ergänzendes Kühlen mit Luft erfolgt. Einem Frequenzumrichter/Inverter kann eine Vorrichtung sein, mit der Gleichstrom frequenzvariabel in Wechselstrom umwandelt wird oder er kann eine Vorrichtung sein, mit der Wechselstrom frequenzvariabel in Wechselstrom anderer Frequenzen umrichtbar ist. Ferner ist ein Frequenzumrichter/Inverter denkbar, mit dem erst Gleichstrom in Wechselstrom einer bestimmten Frequenz umgewandelt werden kann und darauf dieser Wechselstrom weiter frequenzvariabel in Wechselstrom anderer Frequenz umgerichtet werden kann.

Die erfindungsgemäße Heiz- und Klimaanlage hat insbesondere den Vorteil, dass im Wärmepumpenbetrieb das Kühlen des Frequenzumrichters/Inverters wegen der Möglichkeit des Kühlens zu über 70 % der Wärmeableitung von ihm mit Luft nicht so stark ist. Dadurch fällt die Temperatur des Frequenzumrichters/Inverters im Wärmepumpenbetreib nicht zu sehr ab. Somit besteht nicht mehr die Gefahr, dass er, wie vor allem dessen Leistungselektronik, wegen zu geringer Temperatur unzureichend arbeitet und dass sich wegen zu geringer Verdampfungstemperatur Kondensat in ihm bildet und er deshalb Schaden nehmen kann. Hingegen ist im Klimabetrieb durch das Kühlen zu über 70 % der Wärmeableitung von ihm mittels als Sauggas strömenden Kältemittels das Kühlen des Frequenzumrichters/Inverters stark genug. Ein Kühlen des Frequenzumrichters/Inverters hauptsächlich mit Luft wäre bei den bei Klimabetrieb oft hohen Außenlufttemperaturen eher zu gering.

In den Unteransprüchen sind vorteilhafte Ausgestaltungen, Weiterbildungen und Verbesserungen des jeweiligen Gegenstandes der Erfindung angegeben.

Gemäß einer vorteilhaften Ausführung der Heiz- und Klimaanlage ist bei zumindest einem Kältemittelleitungsverlauf im Wärmepumpenbetrieb der Frequenzumrichter/Inverter zu 100% der Wärmeableitung vom Frequenzumrichter/Inverter mit Luft kühlbar. Bei diesem Kältemittelleitungsverlauf liegt dessen Sauggasleitungsabschnitt nicht in Wärmetauschverbindung zum Frequenzumrichter/Inverter. Dadurch kann das Kühlen des Frequenzumrichters/Inverters im Wärmepumpenbetrieb ganz ohne Sauggaskühlung erfolgen, sodass die Gefahr eines zu starken Kühlens besonders gering ist.

Vorzugsweise weist die Heiz- und Klimaanlage im Klimabetrieb einen mittels Ventil schaltbaren weiteren Kältemittelleitungsverlauf stromabwärts vom Innenluftwärmetauscher zum Verdichter ohne Wärmetauschverbindung von als Sauggas strömenden Kältemittel mit dem Frequenzumrichter/Inverter auf. Dieser weitere Kältemittelleitungsverlauf enthält also einen Bypass zum Abschnitt der Wärmetauschverbindung des Kältemittelleitungsverlaufs mit der Wärmetauschverbindung zum Frequenzumrichter/Inverter. Damit besteht vorteilhaft die Möglichkeit der Schaltung des Kältemittelkreislaufs derart, dass auch im Klimabetrieb der Frequenzumrichter/Inverter zumindest zu über 70 % bis zu 100% der Wärmeableitung von ihm mittels Luft gekühlt wird. Dieses verbessert die Möglichkeit der Temperaturregelung des Frequenzumrichters/Inverters.

Gemäß einer vorteilhaften Weiterbildung weist die Heiz- und Klimaanlage auch einen mittels Ventil schaltbaren Kältemittelleitungsverlauf auf, bei dem im Wärmepumpenbetrieb der Frequenzumrichter/Inverter durch im Kältemittelkreislauf stromabwärts vom Außenluftwärmetauscher zum Verdichter als Sauggas strömendes Kältemittel über die Wärmetauschverbindung zu über 70 % der Wärmeableitung vom Frequenzumrichter/Inverter kühlbar ist. Damit besteht vorteilhaft die Möglichkeit der Schaltung des Kältemittelkreislaufs derart, dass auch im Wärmepumpenbetrieb der Frequenzumrichter/Inverter zu einem ganz überwiegenden Teil mittels als Sauggas strömenden Kältemittels gekühlt wird. Dieses verbessert die Möglichkeit der Temperaturregelung des Frequenzumrichters/Inverters, weil er im Wärmepumpenbetrieb damit stärke gekühlt werden kann.

Nach einer vorteilhaften Ausgestaltung weist die Heiz- und Klimaanlage eine Regelung ausgebildet zum Schalten des Kältemittelkreislaufs zwischen dem Kühlen des Frequenzumrichters/Inverters zu über 70 % der Wärmeableitung vom Frequenzumrichter/Inverter mittels als Sauggas bei Betrieb strömenden Kältemittels oder mittels Luft auf. Eine solche Regelung wie beispielsweise eine mit Mikroprozessor ausgestattete Steuereinheit, die das Schalten des jeweils für das momentane Kühlen des Frequenzumrichters/Inverters vorteilhaften Kältemittelleitungsverlaufs im Kältemittelkreislauf regelt, verbessert das Regeln der Temperatur des Frequenzumrichters/Inverters.

Vorzugsweise ist eine Regelung derart ausgebildet, dass damit für das Kühlen des Frequenzumrichters/Inverters mittels als Sauggas bei Betrieb strömenden Kältemittels der Anteil vom Kältemittelstrom dafür regelbar ist. Dabei wird der restliche Teil des Kältemittelstroms durch einen Bypass, ohne den Frequenzumrichter/Inverter zu kühlen, vorbeigeleitet. Dadurch kann das Kühlen des Frequenzumrichters/Inverters besonders flexibel gesteuert werden und so besonders gut an den Kühlbedarf dafür angepasst werden. Je größer der Anteil vom Kältemittelstrom ist, der als Sauggas zum Kühlen des Frequenzumrichters/Inverters eingesetzt wird, desto stärker ist das Kühlen des Frequenzumrichters/Inverters.

Nach einer vorteilhaften Weiterbildung der Heiz- und Klimaanlage ist die Regelung derart ausgebildet, dass von ihr auch der Frequenzumrichter/Inverter regelbar ist. So wird von einer Regelung, wie beispielsweise einer Steuereinheit, sowohl die Drehzahl und Einschaltzeiten des elektrischen Verdichters als auch das Kühlen des Frequenzumrichters/Inverters geregelt. Das spart im Vergleich zu zwei getrennten Regelungen Platz sowie Kosten und ermöglicht ein zusätzliches Steuern des Kühlens des Frequenzumrichters/Inverters über die Drehzahl beziehungsweise Einschaltzeiten des Verdichters und damit der Temperatur und Strömungsstärke des nach dem Verdampfen als Sauggas strömenden Kältemittels.

Nach einer vorteilhaften Ausführung der Heiz- und Klimaanlage ist die Regelung derart ausgebildet, dass von ihr abhängig von einer Temperatur, vorzugsweise von der Temperatur des Frequenzumrichters/Inverters, durch Schalten des Kältemittelkreislaufs das Kühlen des Frequenzumrichters/Inverters zu über 70 % der Wärmeableitung von ihm mittels als Sauggas bei Betrieb strömenden Kältemittels oder zu über 70 % der Wärmeableitung von ihm mittels Luft einstellbar ist. Dadurch wird die Stärke des Kühlens des Frequenzumrichters/Inverters vorteilhaft unmittelbar abhängig von dessen Temperatur geregelt. Dabei wird unter der Temperatur des Frequenzumrichters/Inverters jeweils die Temperatur an der Stelle angesehen, an der die Temperatur abgegriffen wird, wie beispielsweise an seiner Leistungselektronik oder an seiner unteren Bodenplatte. Als Variante ist auch eine Regelung denkbar, die abhängig von der Temperatur des als Sauggas strömenden Kältemittels das Kühlen des Frequenzumrichters/Inverters regelt. Damit wird vorteilhafte direkt abhängig von der jeweiligen Temperatur des für das Kühlen des Frequenzumrichters/Inverters zur Verfügung stehenden Kältemittels geregelt.

Vorzugsweise umfasst die Heiz- und Klimaanlage zum Schalten für den schaltbaren weiteren Kältemittelleitungsverlauf stromabwärts vom Innenluftwärmetauscher zum Verdichter und/oder für den schaltbaren Kältemittelleitungsverlauf stromabwärts vom Außenluftwärmetauscher zum Verdichter wenigstens ein thermostatisches Ventil oder wenigstens ein Magnetventil. Mit einem derartigen Ventil lässt sich ein Kältemittelleitungsverlauf für den Kältemittelstrom im Kältemittelkreislauf besonders einfach, zuverlässig und kostengünstig zu- und abschalten oder auch bei einem den Durchfluss regelbaren Ventil der Anteil vom Kältemittelstrom durch einen Kältemittelleitungsverlauf regeln. Ein thermostatisches Ventil hat beispielsweise den Vorteil, dass die Regelung der Schaltung des Kältemittelleitungsverlaufs im Kältemittelkreislauf abhängig von einer Temperatur direkt vom Ventil umfasst ist. Ein Magnetventil lässt sich vorteilhaft gut von einer als Steuereinheit ausgebildeten Regelung steuern. Besonders vorteilhaft ist zumindest ein Ventil zum Schalten für die schaltbaren Kältemittelleitungsverläufe als regelbares Dreiwegeventil zum für den Strömungsweg des Kältemittels zwischen zwei der Kältemittelleitungsverläufen Einstellen ausgebildet. Dadurch kann einfach der Kältemittelstrom zwischen einem Bypass oder dem Kältemittelleitungsverlauf der Sauggaskühlung des Frequenzumrichters/Inverters geschaltet werden.

Gemäß einer vorteilhaften Ausgestaltung der Heiz- und Klimaanlage ist im Kältemittelkreislauf in einem Kältemittelleitungsverlauf stromabwärts vom Innenluftwärmetauscher eine Kühlplatte mit durch sie oder an ihr verlaufender Kältemittelleitung angeordnet, wobei der Frequenzumrichter/Inverter in thermisch leitender Verbindung zur Kühlplatte derart steht, dass über diese Wärmetauschverbindung der Frequenzumrichter/Inverter bei Betrieb vom als Sauggas strömenden Kältemittel kühlbar ist, und die thermisch leitende Verbindung der Kühlplatte mit dem Frequenzumrichter/Inverter lösbar durch reversible Demontage des Frequenzumrichter/Inverter von der Kühlplatte ausgebildet ist. Dadurch lässt sich der Frequenzumrichter/Inverter effektiv kühlen und, sollte der Ausbau des Frequenzumrichters/Inverters beispielsweise bei dessen Defekt nötig sein, kann vorteilhaft die Kühlplatte im Kältemittelkreis verbleiben. Die Kühlplatte kann so direkt im Kältemittelkreis eingelötet sein und muss deshalb dann nur einmal einer vorgeschrieben Druckprüfung unterzogen werden.

Gemäß einer vorteilhaften Weiterbildung ist zumindest ein Ventil des wenigstens einen Ventils zum Schalten für den schaltbaren weiteren Kältemittelleitungsverlauf stromabwärts vom Innenluftwärmetauscher zum Verdichter und/oder für den schaltbaren Kältemittelleitungsverlauf stromabwärts vom Außenluftwärmetauscher zum Verdichter in die Kühlplatte integriert oder an ihr direkt befestigt. Dieses ist ein vorteilhaft kompakter Aufbau. Das zumindest eine Ventil ist beispielsweise als ein thermostatisches Ventil oder als ein Magnetventil und/oder als ein Dreiwegeventil ausgebildet.

Vorzugsweise ist die Kühlplatte mit dem Strömungsquerschnitt der durch sie oder an ihr verlaufenden Kältemittelleitung für als Sauggas strömendes Kältemittel an den theoretischen maximalen Fördervolumenstrom des jeweiligen Verdichters der Heiz- und Klimaanlage angepasst oder anpassbar. So ist für den Fördervolumenstrom der passende Strömungsquerschnitt der Kältemittelleitung durch die oder an der Kühlplatte ausgewählt, wodurch der Betrieb der Heiz- und Klimaanlage nicht beeinträchtigt wird und eine Sauggaskühlung des Frequenzumrichter/Inverters besonders gut arbeiten kann. Die Anpassung kann beispielsweise durch Auswahl der im Kältemittelkreislauf angeordneten Kühlplatte aus einer Anzahl von Kühlplatten mit unterschiedlichen Strömungsquerschnitten der Kältemittelleitung erfolgen. Auch ist eine Kühlplatte denkbar, deren Strömungsquerschnitt der durch sie oder an ihr verlaufenden Kältemittelleitung je nach eingesetztem Verdichter beispielsweise durch ein in dieser Kältemittelleitung eingeschobenes entsprechendes Rohr anpassbar ist, und sie dann in den Kältemittelkreislauf angeordnet wird.

Besonders vorteilhaft ist ein Strömungsquerschnitt der durch die oder an der Kühlplatte verlaufenden Kältemittelleitung für als Sauggas strömendes Kältemittel, der in mm² zwischen dem 10-fachen und 60-fachen, vorzugsweise dem 15-fachen, des theoretischen maximalen Fördervolumenstroms des Verdichters in m³/h beträgt. Ein Strömungsquerschnitt in diesem Größenbereich ist besonders gut für das Kühlen des auf der Kühlplatte montierten Frequenzumrichters/Inverters sowie für den Betrieb der Heiz- und Klimaanlage angepasst.

Schließlich können die Merkmale der Unteransprüche für die erfindungsgemäße Heiz- und Klimaanlage im Wesentlichen frei miteinander und nicht durch die den Ansprüchen vorliegende Reihenfolge festgelegt kombiniert werden, sofern sie unabhängig voneinander sind und sich nicht gegenseitig ausschließen.

Mit einer Kühlplatte vorgesehen und ausgebildet für den Einbau in den Kältemittelkreislauf einer erfindungsgemäßen Heiz- und Klimaanlage stromabwärts vom Innenluftwärmetauscher mit durch sie oder an ihr verlaufender Kältemittelleitung, wobei auf ihr ein Frequenzumrichter/Inverter in thermisch leitender Verbindung zur Kühlplatte derart wieder lösbar montierbar ist, dass über diese Wärmetauschverbindung der Frequenzumrichter/Inverter bei Betrieb vom als Sauggas durch die Kältemittelleitung der Kühlplatte strömenden Kältemittel kühlbar ist, wird die dem der erfindungsgemäßen Heiz- und Klimaanlage zugrundeliegende Aufgabe entsprechende Aufgabe bezüglich einer Kühlplatte hinsichtlich des Kühlens eines Frequenzumrichters/Inverters gelöst. Bezüglich der Vorteile sowie vorteilhafter Ausgestaltungen und Weiterbildungen und deren Vorzüge wird auf die entsprechenden obigen Angaben zur erfindungsgemäßen Heiz- und Klimaanlage verwiesen.

Die entsprechende Aufgabe bezüglich eines Verfahrens wird durch ein Verfahren zum Regeln des Kühlens des Frequenzumrichters/Inverters beim Betrieb einer erfindungsgemäßen Heiz- und Klimaanlage, wobei abhängig von der Temperatur des Frequenzumrichters/Inverters der Kältemittelkreislauf für das Kühlen des Frequenzumrichters/Inverters zu über 70 % der Wärmeableitung mittels als Sauggas strömenden Kältemittels geschaltet ist beziehungsweise wird oder für das Kühlen des Frequenzumrichters/Inverters zu über 70 % der Wärmeableitung mittels Luft geschaltet ist beziehungsweise wird, gelöst.
Das erfindungsgemäße Verfahren hat den Vorteil, dass beispielsweise im Wärmepumpenbetrieb bei insbesondere wegen der dabei ohnehin schon geringen Außenlufttemperatur eher geringem Kühlbedarf das Kühlen des Frequenzumrichters/Inverters aufgrund des geschalteten Kühlens zu über 70 % der Wärmeableitung mit Luft nicht so stark ist. Dadurch fällt die Temperatur des Frequenzumrichters/Inverters nicht zu sehr ab, denn es wird nicht so viel Wärme von ihm abgeleitet. Somit besteht nicht mehr die Gefahr, dass er, wie vor allem dessen Leistungselektronik, wegen zu geringer Temperatur bei sonst einem Kühlen überwiegend mittels als Sauggas strömenden Kältemittels unzureichend arbeitet, und dass sich wegen zu geringer Verdampfungstemperatur Kondensat in ihm bildet und er deshalb Schaden nehmen kann. Hingegen ist bei geschaltetem Kühlen zu über 70 % der Wärmeableitung mittels als Sauggas strömenden Kältemittels bei eher höherem Kühlbedarf wie normalerweise im Klimabetrieb die Kühlung des Frequenzumrichters/Inverters stark genug.

Vorzugsweise wird für das Kühlen des Frequenzumrichters/Inverters mittels als Sauggas strömenden Kältemittels der Anteil vom Kältemittelstrom dafür in Abhängigkeit vom Kühlbedarf geregelt, wobei damit auch ein Schalten des Kühlens des Frequenzumrichters/Inverters im Bereich von einschließlich 70 % bis zumindest herab bis einschließlich 30 % der Wärmeableitung mittels als Sauggas strömenden Kältemittels ermöglicht wird. Je höher der Kühlbedarf für das Kühlen des Frequenzumrichters/Inverters ist, desto höher ist auch der Anteil vom Kältemittelstrom dafür. Der restliche Teil vom Kältemittelstrom, der im Extremfall bei sehr wenig Kühlbedarf den gesamten Kältemittelstrom ausmachen kann, strömt durch einen Bypass beziehungsweise einen anderen Kältemittelleitungsverlauf so am Frequenzumrichter/Inverter vorbei, dass kein Wärmeaustausch vom Kältemittel mit ihm stattfindet. Mit einem derartigen Verfahren wird der Frequenzumrichters/Inverters besonders flexibel und gut angepasst an seinen Kühlbedarf gekühlt, ohne dass das Kühlen zu stark wird.

### Kurze Beschreibung der Zeichnungen:

Anhand der Zeichnungen werden Ausführungsbeispiele der Erfindung erläutert.

Es zeigen
Fig. 1 ein Ausführungsbeispiel einer erfindungsgemäßen Heiz- und Klimaanlage;
Fig. 2 ein weiteres Ausführungsbeispiel einer erfindungsgemäßen Heiz- und Klimaanlage;
Fig. 3 ein weiteres Ausführungsbeispiel einer erfindungsgemäßen Heiz- und Klimaanlage; und
Fig. 4 ein Ausführungsbeispiel einer Kühlplatte für einen auf ihr montierbaren Frequenzumrichter/Inverter einer erfindungsgemäßen Heiz- und Klimaanlage.

### Ausführliche Beschreibung der Erfindung:

Alle Zeichnungen sind schematisch zu verstehen. Auf maßstabsgetreue Abbildungen wurde zum Zwecke erhöhter Klarheit der Darstellung verzichtet.

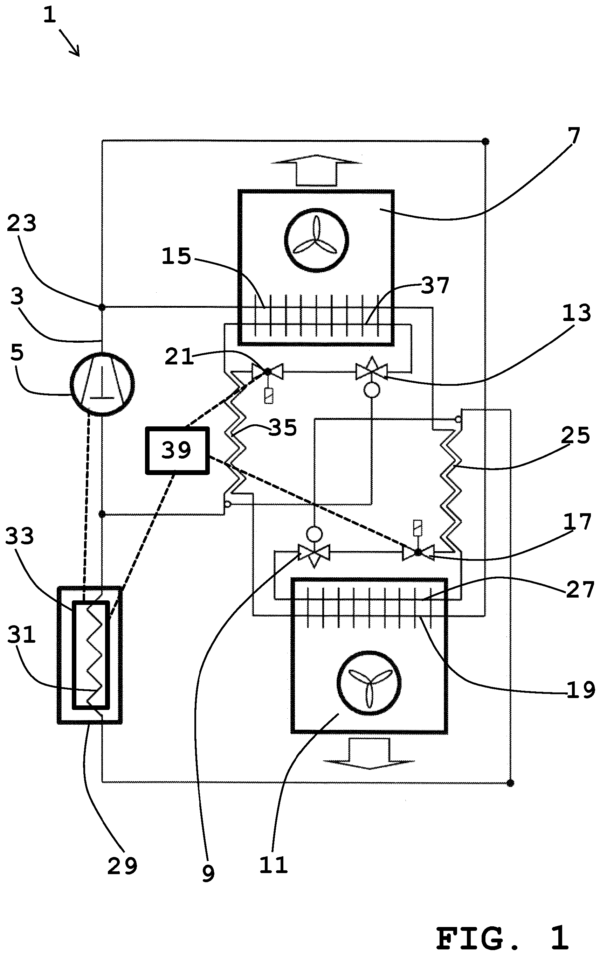

In Fig. 1 ist ein Ausführungsbeispiel einer erfindungsgemäßen Heiz- und Klimaanlage 1 dargestellt. Die Heiz- und Klimaanlage 1 ist für ein Fahrzeug, wie beispielsweise einen Omnibus mit elektrischem Antrieb, einsetzbar. Sie ist zum Heizen im Wärmepumpenbetrieb und umschaltbar zum Kühlen im Klimabetrieb betreibbar ausgebildet. Im Kältemittelkreislauf 3 sind unter anderem ein elektrisch bestreibbarer Verdichter 5 ein Außenluftwärmetauscher 7 zwei Expansionsorgane 9, 13 sowie ein Innenluftwärmetauscher 11 angeordnet. Ferner ist in Kältemittelleitung stromabwärts vom Kondensator-/Gaskühlerbereich 15 des Außenluftwärmetauschers 7 ein als Magnetventil ausgebildetes Ventil 17 noch vor dem ersten Expansionsorgan 9 angeordnet. Außerdem ist nach dem Kondensator-/Gaskühlerbereich 19 des Innenluftwärmetauschers 11 ein weiteres als Magnetventil ausgebildetes Ventil 21 noch vor dem zweiten Expansionsorgan 13 angeordnet. Bei geöffnetem Ventil 17 und geschlossenem Ventil 21 läuft die Heiz- und Klimaanlage 1 im Klimabetrieb, beispielsweise zum Kühlen von Luft eines Fahrgastraums eines Fahrzeugs. Im Klimabetrieb wird der Außenluftwärmetauscher 7 als Kondensator/Gaskühler und der Innenluftwärmetauscher 11 als Verdampfer betrieben. Hingegen läuft die Heiz- und Klimaanlage 1 bei geschlossenem Ventil 17 und geöffnetem Ventil 21 im Wärmepumpenbetrieb, beispielsweise zum Heizen von Luft eines Fahrgastraums eines Fahrzeugs. Im Wärmepumpenbetrieb wird der Außenluftwärmetauscher 7 als Verdampfer und der Innenluftwärmetauscher 11 als Kondensator/Gaskühler betrieben.

Im Klimabetrieb der Heiz- und Klimaanlage 1 führt der Kältemittelleitungsverlauf vom Verdichter 5 über die Verzweigung 23 durch den Kondensator-/Gaskühlerbereich 15 des Außenluftwärmetauschers 7, den optionalen Innenwärmetauscher 25 und das Ventil 17 zum als regelbares Expansionsventil ausgebildeten Expansionsorgan 9. Das dort entspannte Kältemittel strömt weiter durch den Verdampferbereich 27 des Innenluftwärmetauschers 11, durch den optionalen Innenwärmetauscher 25 zur Kühlplatte 29. Das Kältemittel strömt als Sauggas weiter durch die in der Kühlplatte 29 verlaufende Kältemittelleitung 31 hindurch, um schließlich zum Saugeingang des elektrisch betriebenen Verdichters 5 zu gelangen. Die Kältemittelleitung 31 durch die Kühlplatte 29 hat ohne darauf beschränkt zu sein einen Zick-Zack-Verlauf. Denkbar sind bei der Kältemittelleitung 31 durch die Kühlplatte 29 zum Beispiel auch ein gerader mittig längs Verlauf oder ein Verlauf in U-Form, in Ω-Form, in S-Form, in mehrfacher S-Form oder in V-Form, um nur einige der möglichen Verläufe zu nennen. Die durch die Kühlplatte 29 verlaufende Kältemittelleitung 31 ist in dem Fall ein Kanal durch die aus Aluminium bestehende Kühlplatte 29. Die Kühlplatte 29 kann auch aus einem anderen gut wärmeleitenden Material wie beispielsweise Kupfer oder Stahl bestehen. Ferner ist denkbar, dass die Kältemittelleitung 31 als Rohr durch einen Kanal in der Kühlplatte 29 verläuft, wobei die als Rohr ausgebildete Kältemittelleitung 31 in Wärmetauschverbindung mit der Kühlplatte 29 steht. Denkbar ist außerdem, dass eine als Rohr ausgebildete Kältemittelleitung 31 derart durch die Kühlplatte 29 verläuft, dass sie in einer in der Kühlplatte 29 passend vorgefertigten Nut eingefügt ist. Ferner ist denkbar, dass die Kältemittelleitung 31 lediglich in Wärmetauschverbindung mit der Kühlplatte 29 an deren Unterseite angelötet ist.
Auf der Kühlplatte 29 ist ein Frequenzumrichter/Inverter 33 montiert. Seine Bodenplatte ist mit der Kühlplatte 29 verschraubt. Es sind auch andere bekannte Arten von lösbarer thermisch leitender Verbindung des Frequenzumrichters/Inverters 33 mit der Kühlplatte 29 denkbar, wie beispielsweise mittels Klemmen, die mit ihren Füßen in hinterschnittenen Nuten der Kühlplatte 29 befestigt sind. Durch die thermisch leitende Verbindung mit der Kühlplatte 29 steht der Frequenzumrichter/Inverter 33 auch in Wärmetauschverbindung mit dem als Sauggas bei Klimabetrieb durch die Kältemittelleitung 31 der Kühlplatte 29 strömenden Kältemittel. Somit ist der Frequenzumrichter/Inverter 33 bei diesem Kältemittelleitungsverlauf im Klimabetrieb durch im Kältemittelkreislauf 3 stromabwärts vom Innenluftwärmetauscher 11 zum Verdichter 5 als Sauggas strömendes Kältemittel über eine Wärmetauschverbindung kühlbar. Über diese Art des Kühlens erfolgt im Klimabetrieb über 70 % der Wärmeableitung vom Frequenzumrichter/Inverter 33. Insbesondere an der Leistungselektronik des Frequenzumrichter/Inverter 33 fällt viel Wärme an, die, um eine Überhitzung des Frequenzumrichters/Inverters 33 bei Klimabetrieb zu vermeiden, zum ganz überwiegenden Teil, also deutlich über 70 %, durch das Kühlen mit als Sauggas strömenden Kältemittel abgeführt wird. Der Anteil, der vom Frequenzumrichter/Inverter 33 ihn umgebenen Luft gleichzeitig abgegebenen Wärme, ist im Vergleich dazu wegen der besonders effektiven Sauggaskühlung mit unter 30 % gering und sogar wegen bei Klimabetrieb oft hoher Außenlufttemperaturen häufig nahezu vernachlässigbar. Mit dem Frequenzumrichter/Inverter 33 wird die Drehzahl des elektrisch betriebenen Verdichters 5 und somit dessen Leistung geregelt. Die Verbindung zum Regeln des Verdichters 5 ist in Fig. 1 als gestrichelte Linie dargestellt. Es gibt Ausführungsbeispiele von Frequenzumrichtern/Invertern 33, deren Temperatur, wie zum Beispiel an seiner Leistungselektronik, nicht deutlich über 60 °C liegen sollte, denn sonst besteht die Gefahr, dass sie nicht mehr ordnungsgemäß laufen oder gar defekt werden.

Im Wärmepumpenbetrieb der Heiz- und Klimaanlage 1 ist der Kältemittelleitungsverlauf ein anderer als im Klimabetrieb. Im Wärmepumpenbetrieb führt der Kältemittelleitungsverlauf vom Verdichter 5 über die Verzweigung 23 durch den Kondensator-/Gaskühlerbereich 19 des Innenluftwärmetauschers 11, den zweiten optionalen Innenwärmetauscher 35 und das Ventil 21 zum als regelbares Expansionsventil ausgebildeten zweiten Expansionsorgan 13. Das dort entspannte Kältemittel strömt weiter durch den Verdampferbereich 37 des Außenluftwärmetauschers 7, durch den optionalen zweiten Innenwärmetauscher 35 direkt zum Saugeingang des elektrisch betriebenen Verdichters 5. Im Wärmepumpenbetrieb ist in den Kältemittelleitungsverlauf die Kühlplatte 29 nicht eingebunden. Durch die Kühlplatte 29 strömt somit kein Kältemittel, so dass dann kein Kühlen des Frequenzumrichters/Inverters 33 durch Sauggas erfolgt. Der Frequenzumrichter/Inverter 33 wird deshalb lediglich durch die Luft, die ihn umgibt oder umströmt, gekühlt. Er ist somit im Wärmepumpenbetrieb der Heiz- und Klimaanlage 1 zu 100 %, also zu über 70 %, der Wärmeableitung von ihm mit Luft kühlbar. Das Kühlen mit Luft beispielsweise durch Konvektion erfolgt mit Außenluft. Normalerweise ist im Wärmepumpenbetrieb zum Heizen die Außenluft deutlich kühler als im Klimabetrieb der Heiz- und Klimaanlage 1. Somit ist das Kühlen des Frequenzumrichters/Inverters 33 mit nur Luft im Wärmepumpenbetrieb im Vergleich zum Klimabetrieb ausreichend. Außerdem erreicht das als Sauggas nach dem Verdampfer strömende Kältemittel im Wärmepumpenbetrieb niedrigere Temperaturen als im Klimabetrieb. Aus diesen Gründen würde bei einer wie beim Klimabetrieb überwiegenden Sauggaskühlung des Frequenzumrichters/Inverters 33 im Wärmepumpenbetrieb die Gefahr bestehen, dass die Temperatur des Frequenzumrichters/Inverters 33 zu stark sogar unter 0 °C absinken könnte und damit sich dort Kondensat bilden könnte, was insbesondere dessen Leistungselektronik schaden würde.
Die als Steuereinheit ausgebildete Regelung 39 steuert den Frequenzumrichter/Inverter 33 und damit die Verdichterleistung. Ferner werden von der als Steuereinheit ausgebildeten Regelung 39 die Ventile 17 und 21 dahingehend geregelt, dass je nach Bedarf die Heiz- und Klimaanlage 1 auf Wärmepumpenbetrieb oder Klimabetrieb geschaltet wird. Von der als Steuereinheit ausgebildeten Regelung 39 wird auch die ermittelte Temperatur des Frequenzumrichters/Inverters 33 berücksichtigt. Sinkt diese Temperatur im Klimabetrieb wegen des Kühlens überwiegenden mit Sauggas zu stark ab, so wird die Heiz- und Klimaanlage 1 von der als Steuereinheit ausgebildeten Regelung 39 kurzzeitig auf Wärmepumpenbetrieb umgeschaltet, sodass für kurze Zeit das Kühlen des Frequenzumrichters/Inverters 33 nur mit Luft erfolgt. Andererseits bei zu großem Anstieg der Temperatur des Frequenzumrichters/Inverters 33 im Wärmepumpenbetrieb wird kurzzeitig auf Klimabetrieb umgeschaltet, sodass für kurze Zeit das effektivere Kühlen des Frequenzumrichters/Inverters 33 wie beschrieben mit über 70 % der Wärmeableitung von ihm mittels als Sauggas strömenden Kältemittels erfolgt. Bei ausreichendem Abkühlen des Frequenzumrichters/Inverters 33 wird dann wieder auf Wärmepumpenbetrieb umgeschaltet.

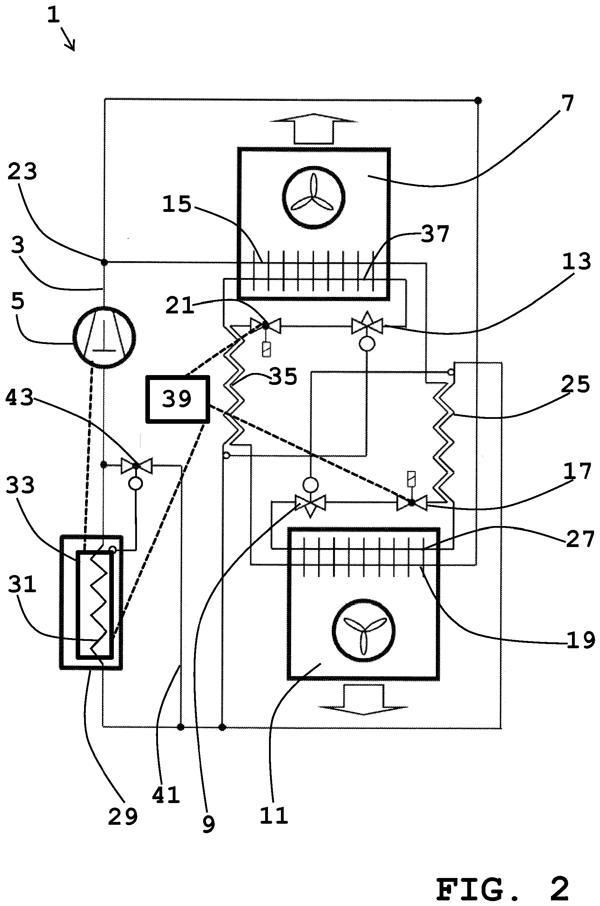

In Fig. 2 ist ein weiteres Ausführungsbeispiel einer erfindungsgemäßen Heiz- und Klimaanlage 1 gezeigt. Ihr Aufbau entspricht in weiten Teilen dem in Fig. 1 gezeigten Ausführungsbeispiel. So sind entsprechend im Kältemittelkreislauf 3 ein elektrisch betreibbarer Verdichter 5, die Verzweigung 23, der Außenluftwärmetauscher 7 samt Kondensator-/Gaskühlerbereich 15 sowie Verdampferbereich 37, die zwei optionalen Innenwärmetauschern 25, 35, die zwei Ventilen 17, 21 zum Umschalten zwischen Wärmepumpenbetrieb und Klimabetrieb, die zwei Expansionsorganen 9, 13, der Innenluftwärmetauscher 11 samt Kondensator-/Gaskühlerbereich 19 sowie Verdampferbereich 27 und die Kühlplatte 29 samt ihrer Kältemittelleitung 31 angeordnet. Auf der Kühlpatte 29 ist auch der Frequenzumrichter/Inverter 33 in thermisch leitender Verbindung wieder lösbar montiert. Mit dem Frequenzumrichter/Inverter 33 wird die Drehzahl des elektrisch betreibbaren Verdichters 5 und damit dessen Leistung und somit die Leistung der Heiz- und Klimaanlage 1 geregelt. Im Klimabetrieb der Heiz- und Klimaanlage 1 wird der Außenluftwärmetauscher 7 als Kondensator/Gaskühler und der Innenluftwärmetauscher 11 als Verdampfer und im Wärmepumpenbetrieb der Außenluftwärmetauscher 7 als Verdampfer und der Innenluftwärmetauscher 11 als Kondensator/Gaskühler betrieben.

Jedoch führt der Kältemittelleitungsverlauf für den Wärmepumpenbetrieb zum Kältemittelleitungsabschnitt vor der Kühlplatte 29, sodass im Kältemittelkreislauf 3 zumindest ein Teil des als Sauggas strömenden Kältemittels auch im Wärmepumpenbetrieb durch die durch die Kühlplatte 29 verlaufende Kältemittelleitung 31 strömt. Parallel zur durch die Kühlplatte 29 verlaufenden Kältemittelleitung 31 ist ein Bypass 41 für als Sauggas strömendes Kältemittel angeordnet, der keine thermisch leitende Verbindung zur Kühlplatte 29 mit Wärmetauschverbindung zum Frequenzumrichter/Inverter 33 hat. In diesem Bypass 41 ist ein thermostatisches Ventil 43 angeordnet, das abhängig von der Temperatur des Frequenzumrichter/Inverters 33 mit eigener Regelung den Bypass 41 für als Sauggas strömendes Kältemittel verschließt oder öffnet. Die Temperatur des Frequenzumrichters/Inverters 33 wird dafür an dessen Leistungselektronik abgegriffen. Denkbar ist auch die Temperatur an seiner Bodenplatte abzugreifen. Als Variante ist beispielsweise statt eines thermostatischen Ventils 43 ein regelbares Magnetventil im Bypass 41 angeordnet, das von einer extra Regelung 39 abhängig von der Temperatur des Frequenzumrichters/Inverters 33 geregelt wird. Sowohl im Klimabetrieb als auch im Wärmepumpenbetrieb, strömt als Sauggas bei geöffnetem Bypass 41 ein Großteil des Kältemittels durch den Bypass 41 an der Kühlplatte 29 vorbei. Nur ein sehr geringer Anteil des als Sauggas strömenden Kältemittels strömt bei geöffnetem Bypass 41 durch die Kältemittelleitung 31 der Kühlplatte 29. Somit macht bei geöffnetem thermostatischem Ventil 43 des Bypasses 41 das Kühlen des Frequenzumrichters/Inverters 33 mittels Sauggas nur einen kleinen Anteil der Wärmeableitung von ihm aus. Der restliche Großteil der Wärmeableitung von über 70 % vom Frequenzumrichter/Inverter 33 erfolgt mittels Luft. In diesem Ausführungsbeispiel wird dazu Außenluft benutzt. Damit existiert ein Kältemittelleitungsverlauf, bei dem der Frequenzumrichter/Inverter 33 im Wärmepumpenbetrieb zu über 70 % der Wärmeableitung vom Frequenzumrichter/Inverter 33 mit Luft kühlbar ist. Ferner existiert im Klimabetrieb neben der Kältemittelleitung 31 durch die Kühlplatte 29 mit dem Bypass 41 ein mittels des thermostatischen Ventils 43 schaltbarer weiterer Kältemittelleitungsverlauf stromabwärts vom Innenluftwärmetauscher 11 zum Verdichter 5 ohne Wärmetauschverbindung von als Sauggas strömenden Kältemittel mit dem Frequenzumrichter/Inverter 33.

Bei geschlossenem thermostatischen Ventil 43 strömt sowohl im Klimabetrieb als auch im Wärmepumpenbetrieb kein Kältemittel durch den Bypass 41, sondern vollständig als Sauggas durch die Kältemittelleitung 31 der Kühlplatte 29. Dabei wird der auf der Kühlplatte 29 in thermisch leitender Verbindung zum Beispiel mit Schrauben wieder lösbar montierte Frequenzumrichter/Inverter 33 über eine Wärmetauschverbindung zum ganz überwiegenden Teil durch als Sauggas strömendes Kältemittel gekühlt. Diese Sauggaskühlung macht dann über 70 % der Wärmeableitung vom Frequenzumrichter/Inverter 33 aus. Seine Leistungselektronik produziert bei Betrieb besonders viel Wärme. Nur ein kleiner Rest der Wärmeableitung von ihm erfolgt dabei durch die Außenluft. Somit existiert im Klimabetrieb auch ein Kältemittelleitungsverlauf, bei dem der Frequenzumrichter/Inverter 33 durch im Kältemittelkreislauf 3 stromabwärts vom Innenluftwärmetauscher 11 zum Verdichter 5 als Sauggas strömendes Kältemittel über eine Wärmetauschverbindung zu über 70 % der Wärmeableitung von ihm kühlbar ist. Ferner weist die Heiz- und Klimaanlage 1 so auch einen mittels des thermostatischen Ventils 43, nämlich durch dessen Schließen, schaltbaren Kältemittelleitungsverlauf auf, bei dem im Wärmepumpenbetrieb der Frequenzumrichter/Inverter 33 durch im Kältemittelkreislauf 3 stromabwärts vom Außenluftwärmetauscher 7 zum Verdichter 5 als Sauggas strömendes Kältemittel über die Wärmetauschverbindung zu über 70 % der Wärmeableitung vom Frequenzumrichter/Inverter 33 kühlbar ist.
Die als Steuereinheit ausgebildete Regelung 39 steuert den Frequenzumrichter/Inverter 33 und damit die Verdichterleistung. Ferner werden von der Regelung 39 die Ventile 17 und 21 dahingehend geregelt, dass je nach Bedarf die Heiz- und Klimaanlage 1 auf Wärmepumpenbetrieb oder Klimabetrieb geschaltet wird.

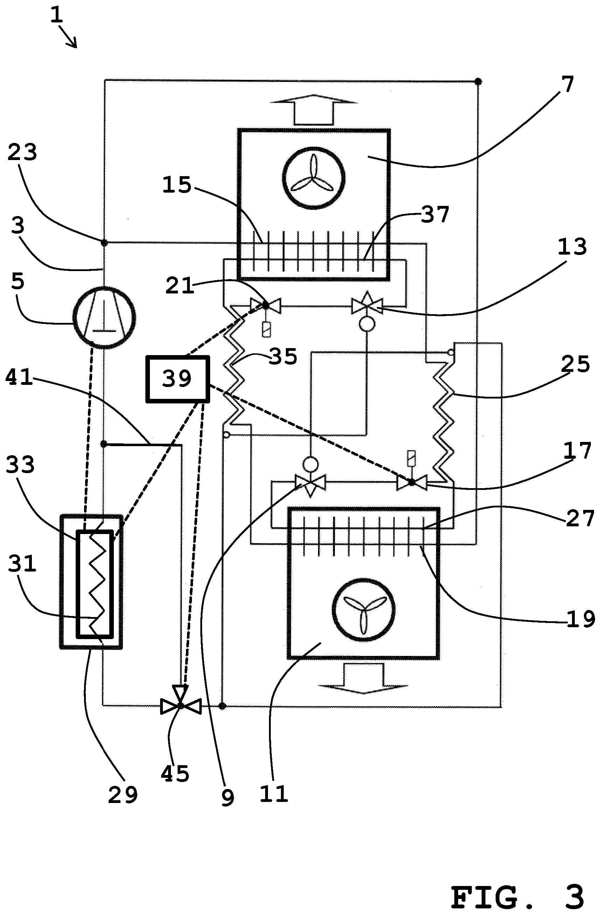

Das in Fig. 3 gezeigte weitere Ausführungsbeispiel einer Heiz- und Klimaanlage 1 entspricht bis auf das regelbare Dreiwegeventil 45 statt des thermostatischen Ventils 43 dem in Fig. 2 dargestellten Ausführungsbeispiel, sodass dementsprechend auf die Beschreibung zu Fig. 2 samt Bezugszeichen verwiesen wird. Das Dreiwegeventil 45 ist in der Verzweigung der Kältemittelleitung einerseits zum Bypass 41 und anderseits zur Kühlplatte 29 im Kältemittelkreislauf 3 angeordnet. Es wird von der Regelung 39 geregelt. Damit lässt sich der Strömungsweg des Kältemittels zwischen dem Bypass 41 und der durch die Kühlplatte 29 verlaufenden Kältemittelleitung 31 einstellen. Bei Schaltung des regelbaren Dreiwegeventils 45 auf Verschluss des Bypasses 41 und Öffnung der Kältemittelleitung zur durch die Kühlplatte 29 verlaufenden Kältemittelleitung 31 ist die Sauggaskühlung des Frequenzumrichters/Inverters 33 sowohl beim Klimabetrieb als auch beim Wärmepumpenbetrieb im vollen Umfang aktiviert. Ohne darauf beschränkt zu sein beträgt in diesem Ausführungsbeispiel der Strömungsquerschnitt der durch die Kühlplatte 29 verlaufenden Kältemittelleitung 31 in mm² dem 15-fachen des theoretischen maximalen Fördervolumenstroms des Verdichters 5 in m³/h. Das gesamte als Sauggas strömende Kältemittel strömt dabei durch die Kühlplatte 29 und nimmt über die Wärmeleitverbindung mit dem auf der Kühlplatte 29 montierten Frequenzumrichter/Inverter 33 einen Großteil der Wärme von ihm auf. Die Wärmeableitung durch das als Sauggas strömende Kältemittel macht dabei über 70 % der gesamten Wärmeableitung vom Frequenzumrichter/Inverter 33 aus. Im Klimabetrieb liegt dabei die Kältemittelleitung 31 der Kühlplatte 29 stromabwärts vom Innenwärmetauscher 11 zum Verdichter 5 und im Wärmepumpenbetrieb stromabwärts vom Außenwärmetauscher 7 zum Verdichter 5.

Bei Schaltung des regelbaren Dreiwegeventils 45 auf Öffnung des Bypasses 41 und Verschluss der Kältemittelleitung zur durch die Kühlplatte 29 verlaufenden Kältemittelleitung 31 ist die Sauggaskühlung des Frequenzumrichters/Inverters 33 sowohl beim Klimabetrieb als auch beim Wärmepumpenbetrieb ausgeschaltet. Das gesamte Kältemittel strömt dabei durch den Bypass 41 an der Kühlplatte 29 vorbei. Der Frequenzumrichter/Inverter 33 wird dann nur mit der Außenluft gekühlt. Somit existiert sowohl für den Klimabetrieb als auch für den Wärmepumpenbetrieb jeweils ein mittels Dreiwegeventil 45 schaltbarer Kältemittelleitungsverlauf, bei dem der Frequenzumrichter/Inverter 33 mit über 70 % ja sogar zu 100 % der Wärmeableitung vom Frequenzumrichter/Inverter 33 mittels Luft kühlbar ist. Die Regelung 39 regelt mit entsprechender Schaltung des Dreiwegeventils 45 das Kühlen des Frequenzumrichters/Inverters 33 beim Betrieb der Heiz- und Klimaanlage 1 in der Weise, das abhängig von der Temperatur des Frequenzumrichters/Inverters 33 der Kältemittelkreislauf 3 für das Kühlen des Frequenzumrichters/Inverters 33 zu über 70 % der Wärmeableitung mittels als Sauggas strömenden Kältemittels geschaltet ist beziehungsweise wird oder für das Kühlen des Frequenzumrichters/Inverters 33 zu über 70 % der Wärmeableitung mittels Luft geschaltet ist beziehungsweise wird. Wenn die Temperatur des Frequenzumrichters/Inverters 33 eine vorbestimmte Temperatur von beispielsweise 0 °C unterschreitet, wird oder ist das Dreiwegeventil 45 so geschaltet, dass der Frequenzumrichter/Inverter 33 nur mit Luft gekühlt wird. Hingegen wird oder ist bei Betrieb der Heiz- und Klimaanlage 1 das Dreiwegeventil 45 bei Überschreiten einer vorbestimmten Temperatur des Frequenzumrichters/Inverters 33 von beispielsweise 50 °C auf Verschluss des Bypasses 41 und Öffnung der Kältemittelleitung zur Kühlplatte 29 geschaltet, sodass das Kühlen des Frequenzumrichters/Inverters 33 zu über 70 % der Wärmeableitung mittels als Sauggas strömenden Kältemittels erfolgt. Die Temperatur des Frequenzumrichters/Inverters 33 wird dafür an dessen Leistungselektronik oder beispielsweise an seiner Bodenplatte abgegriffen.

Die Regelung 39 regelt auch den Frequenzumrichter/Inverter 33 und damit die Drehzahl des elektrisch betreibbaren Verdichters 5. Ferner werden von der Regelung 39 die Ventile 17 und 21 dahingehend geregelt, dass je nach Bedarf die Heiz- und Klimaanlage 1 auf Wärmepumpenbetrieb oder Klimabetrieb geschaltet wird. Damit kann beispielsweise Luft eines Fahrgastraums eines Elektroomnibusses temperiert werden.

Das regelbare Dreiwegeventil 45 ist beispielsweise nach einer Ausgestaltung der Heiz- und Klimaanlage 1 direkt an der Kühlplatte 29 befestigt, sodass die Kühlplatte 29 und das Dreiwegeventil 45 eine Einheit bilden.

Denkbar ist auch ein regelbares Dreiwegeventil 45, bei dem die Kältemittelströmung regelbar in zwei Anteile aufteilbar ist, also der eine Anteil des Kältemittelstroms den einen Strömungsweg und der restliche Anteil des Kältemittelstroms den anderen Strömungsweg nimmt. Mit einer ein derartiges Dreiwegeventil 45 regelnden Regelung 39 kann für das Kühlen des Frequenzumrichters/Inverters 33 mittels als Sauggas bei Betrieb strömenden Kältemittels der Anteil vom Kältemittelstrom dafür geregelt werden. Der restliche Anteil des Kältemittelstroms im Kältemittelkreislauf 3 strömt dabei durch den Bypass 41. Somit lässt sich damit für das Kühlen des Frequenzumrichters/Inverters 33 mittels als Sauggas strömenden Kältemittels der Anteil vom Kältemittelstrom dafür in Abhängigkeit vom Kühlbedarf stufenlos von 0 bis 100 % einstellen, wobei neben den Schaltmöglichkeiten erstens des Kühlens des Frequenzumrichters/Inverters 33 zu über 70 % der Wärmeableitung mittels als Sauggas strömenden Kältemittels und zweitens des Kühlens des Frequenzumrichters/Inverters 33 zu über 70 % der Wärmeableitung mittels Luft damit drittens das Schalten des Kühlens des Frequenzumrichters/Inverters 33 im Bereich von einschließlich 70 % bis zumindest herab bis einschließlich 30 % der Wärmeableitung mittels als Sauggas strömenden Kältemittels ermöglicht wird.

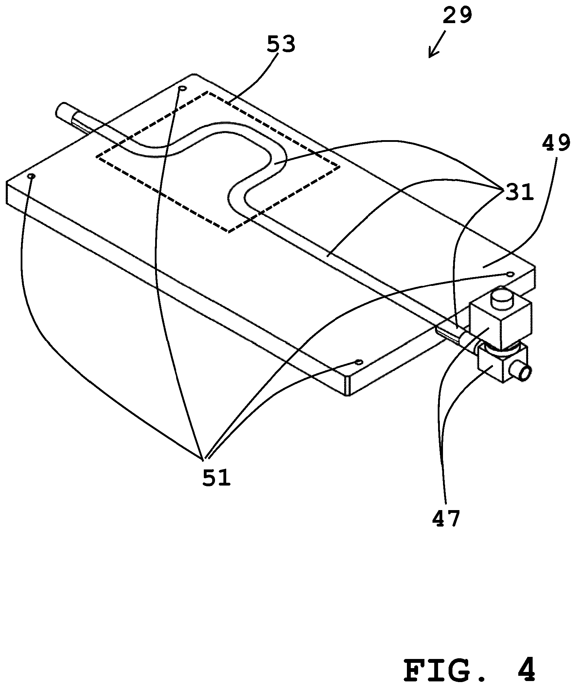

In Fig. 4 ist ein Ausführungsbeispiel einer Kühlplatte 29 für einen Frequenzumrichter/Inverter einer erfindungsgemäßen Heiz- und Klimaanlage dargestellt. Durch die im Wesentlichen als flacher Quader ausgeformte Kühlplatte 29 verläuft die Kältemittelleitung 31. Die Kältemittelleitung 31 ist dafür in diesem Beispiel in eine Nut der Kühlplatte 29 passgenau eingefügt. Die so eingefügte Kältemittelleitung 31 verläuft erst mittig der oberen Montagefläche 49 in Längsrichtung der Kühlplatte 29, dann im hinteren Bereich der Montagefläche 49 in U-Form und schließlich führt sie mittig an der hinteren kurzen Seite der Kühlplatte 29 heraus. Die in die Nut der Kühlplatte 29 eingefügte Kältemittelleitung 31 ist in ihrem oberen Bereich abgeflacht und bildet so mit der Montagefläche 49 der Kühlplatte 29 eine ebene Fläche. Auf dem gestrichelt gekennzeichnete Bereich, in dem der U-förmige Verlauf der Kältemittleitung 31 liegt, ist bei auf der Montagefläche 49 der Kühlplatte 29 montiertem Frequenzumrichter/Inverter der Sitz dessen Leistungselektronik, die bei Betrieb besonders gut zu kühlen wäre. Die viereckige Montagefläche 49 weist im Bereich ihrer Ecken jeweils ein Gewindeloch 51 auf. Ein auf der der Montagefläche 49 zu montierender Frequenzumrichter/Inverter wird so mit seiner Bodenplatte mittels entsprechender Schrauben an der Kühlplatte 29 festgeschraubt. Bei Wartung oder Austausch des Frequenzumrichters/Inverters wäre dieser wieder abschraubbar. Zwischen der Kältemittelleitung 31 und damit auch einem durch sie als Sauggas strömenden Kältemittel und der Kühlplatte 29 besteht eine thermisch leitende Verbindung. Die Kältemittelleitung 31 und die Kühlplatte 29 mit ihrer Montagefläche 49 sind aus gut wärmeleitendem Metall wie beispielsweise Aluminium. Ein Frequenzumrichter/Inverter mit seiner ebenfalls gut wärmeleitenden metallischen Bodenplatte steht, sofern auf der Montagefläche 49 der Kühlplatte 29 montiert, in guter Wärmetauschverbindung zur Kühlplatte 29 und damit zur Kältemittelleitung 31 sowie zum durch diese Kältemittelleitung 31 bei Klimabetrieb einer erfindungsgemäßen Heiz- und Klimaanlage als Sauggas strömenden Kältemittel. Mit Wärmeleitpaste zwischen Montagefläche 49 der Kühlplatte 29 und Bodenplatte eines zu montierenden Frequenzumrichters/Inverters wird die thermisch leitende Verbindung noch erhöht. An der Kühlplatte 29 mit Kältemittelleitung 31 befindet sich ein regelbares Magnetventil 47. Es ist in der Kältemittelleitung 31 und somit direkt an der Kühlplatte 29 angeordnet. Mit diesem fest mit der Kühlplatte 29 verbundenen Magnetventil 47 kann die durch die Kühlplatte 29 verlaufende Kältemittelleitung 31 für einen Kältemittelstrom verschlossen und geöffnet werden. In einer erfindungsgemäßen Heiz- und Klimaanlage kann so regelbar bei geöffnetem Magnetventil 47 das Kältemittel durch die Kältemittelleitung 31 der Kühlplatte 29 als Sauggas strömen und damit den auf der Kühlplatte 29 montierten Frequenzumrichter/Inverter zu über 70 % der Wärmeableitung von ihm kühlen oder bei geschlossenem Magnetventil 47 nicht durch die Kühlplatte strömen sondern durch einen Bypass an ihr vorbei, wobei dann das Kühlen des Frequenzumrichters/Inverters nur mit Luft erfolgt.

Denkbar ist eine Ausführung der Kühlplatte 29 mit noch weiteren Gewindelöchern in der Montagefläche 49 zum Anschrauben von einem Frequenzumrichter/Inverter mit anderen Abmessungen, sodass Frequenzumrichter/Inverter unterschiedlicher Baugröße und Leistung auf einer derartigen Kühlplatte 29 montierbar sind.

Ferner ist auch eine Ausführung der Kühlplatte 29 mit einem anderen Verlauf der Kältemittelleitung 31 wie beispielsweise einem Verlauf in Form eines I, S, mehrfach S oder Ω denkbar.
Außerdem ist eine Ausführung der Kühlplatte 29, bei der der Strömungsquerschnitt der durch sie verlaufenden Kältemittelleitung 31 ein anderer ist, denkbar.

## Patentansprüche

1. Heiz- und Klimaanlage (1) für ein Fahrzeug, die zum Heizen im Wärmepumpenbetrieb und umschaltbar zum Kühlen im Klimabetrieb betreibbar ausgebildet ist, mit einem Kältemittelkreislauf (3) umfassend wenigstens einen elektrisch betreibbaren Verdichter (5), einen Außenluftwärmetauscher (7), ein Expansionsorgan (9, 13) und einen Innenluftwärmetauscher (11), derart ausgebildet, dass im Klimabetrieb der Außenluftwärmetauscher (7) als Kondensator/Gaskühler und der Innenluftwärmetauscher (11) als Verdampfer und im Wärmepumpenbetrieb der Außenluftwärmetauscher (7) als Verdampfer und der Innenluftwärmetauscher (11) als Kondensator/Gaskühler betreibbar sind, und der Verdichter (5) in seiner Drehzahl über einen Frequenzumrichter/Inverter (33) regelbar ist,
wobei
der Frequenzumrichter/Inverter (33) derart angeordnet ist, dass er bei zumindest einem Kältemittelleitungsverlauf im Klimabetrieb durch im Kältemittelkreislauf (3) stromabwärts vom Innenluftwärmetauscher (11) zum Verdichter (5) als Sauggas strömendes Kältemittel über eine Wärmetauschverbindung zu über 70 % der Wärmeableitung
vom Frequenzumrichter/Inverter (33) kühlbar ist, **gekennzeichnet durch** einen Kältemittelleitungsverlauf, der
im Wärmepumpenbetrieb über wenigstens einen für als Sauggas strömendes Kältemittel angeordneten Kältemittelleitungsabschnitt vom Außenluftwärmetauscher (7) zum Verdichter (5) ohne Wärmetauschverbindung mit dem Frequenzumrichter/Inverter (33) verläuft, und
der Frequenzumrichter/Inverter (33) im Wärmepumpenbetrieb zu über 70 % der Wärmeableitung
vom Frequenzumrichter/Inverter (33) mit Luft kühlbar ist.

2. Heiz- und Klimaanlage (1) nach Anspruch 1 **dadurch gekennzeichnet, dass** bei zumindest einem Kältemittelleitungsverlauf im Wärmepumpenbetrieb der Frequenzumrichter/Inverter (33) zu 100% der Wärmeableitung vom Frequenzumrichter/Inverter (33) mit Luft kühlbar ist.

3. Heiz- und Klimaanlage (1) nach Anspruch 1 oder 2 **dadurch gekennzeichnet, dass** sie im Klimabetrieb einen mittels Ventil (43, 45, 47) schaltbaren weiteren Kältemittelleitungsverlauf stromabwärts vom Innenluftwärmetauscher (11) zum Verdichter (5) ohne Wärmetauschverbindung von als Sauggas strömenden Kältemittel mit dem Frequenzumrichter/Inverter (33) aufweist.

4. Heiz- und Klimaanlage (1) nach einem der Ansprüche 1 bis 3 **dadurch gekennzeichnet, dass** sie auch einen mittels Ventil (43, 45, 47) schaltbaren Kältemittelleitungsverlauf aufweist, bei dem im Wärmepumpenbetrieb der Frequenzumrichter/Inverter (33) durch im Kältemittelkreislauf stromabwärts vom Außenluftwärmetauscher (7) zum Verdichter (5) als Sauggas strömendes Kältemittel über die Wärmetauschverbindung zu über 70 % der Wärmeableitung vom Frequenzumrichter/Inverter (33) kühlbar ist.

5. Heiz- und Klimaanlage (1) nach einem der Ansprüche 1 bis 4 **dadurch gekennzeichnet, dass** sie eine Regelung (39) ausgebildet zum Schalten des Kältemittelkreislaufs (3) zwischen dem Kühlen des Frequenzumrichters/Inverters (33) zu über 70 % der Wärmeableitung vom Frequenzumrichter/Inverter (33) mittels als Sauggas bei Betrieb strömenden Kältemittels oder mittels Luft aufweist.

6. Heiz- und Klimaanlage (1) nach einem der Ansprüche 1 bis 5 **dadurch gekennzeichnet, dass** eine Regelung (39) derart ausgebildet ist, dass damit für das Kühlen des Frequenzumrichters/Inverters (33) mittels als Sauggas bei Betrieb strömenden Kältemittels der Anteil vom Kältemittelstrom dafür regelbar ist.

7. Heiz- und Klimaanlage (1) nach Anspruch 5 oder 6 **dadurch gekennzeichnet, dass** die Regelung (39) derart ausgebildet ist, dass von ihr auch der Frequenzumrichter/Inverter (33) regelbar ist.

8. Heiz- und Klimaanlage (1) nach einem der Ansprüche 5 bis 7 **dadurch gekennzeichnet, dass** die Regelung (39) derart ausgebildet ist, dass von ihr abhängig von einer Temperatur, vorzugsweise von der Temperatur des Frequenzumrichters/Inverters (33), durch Schalten des Kältemittelkreislaufs (3) das Kühlen des Frequenzumrichters/Inverters (33) zu über 70 % der Wärmeableitung von ihm mittels als Sauggas bei Betrieb strömenden Kältemittels oder zu über 70 % der Wärmeableitung von ihm mittels Luft einstellbar ist.

9. Heiz- und Klimaanlage (1) nach einem der Ansprüche 3 bis 8 **dadurch gekennzeichnet, dass** sie zum Schalten für den schaltbaren weiteren Kältemittelleitungsverlauf stromabwärts vom Innenluftwärmetauscher (11) zum Verdichter (5) und/oder für den schaltbaren Kältemittelleitungsverlauf stromabwärts vom Außenluftwärmetauscher (7) zum Verdichter (5) wenigstens ein thermostatisches Ventil (43) oder wenigstens ein Magnetventil (47) umfasst.

10. Heiz- und Klimaanlage (1) nach einem der Ansprüche 3 bis 9 **dadurch gekennzeichnet, dass** zumindest ein Ventil (43, 45, 47) zum Schalten für die schaltbaren Kältemittelleitungsverläufe als regelbares Dreiwegeventil (45) zum für den Strömungsweg des Kältemittels zwischen zwei der Kältemittelleitungsverläufen Einstellen ausgebildet ist/sind.

11. Heiz- und Klimaanlage (1) nach einem der Ansprüche 1 bis 10 **dadurch gekennzeichnet, dass** im Kältemittelkreislauf (3) in einem Kältemittelleitungsverlauf stromabwärts vom Innenluftwärmetauscher (11) eine Kühlplatte (29) mit durch sie oder an ihr verlaufender Kältemittelleitung (31) angeordnet ist, wobei der Frequenzumrichter/Inverter (33) in thermisch leitender Verbindung zur Kühlplatte (29) derart steht, dass über diese Wärmetauschverbindung der Frequenzumrichter/Inverter (33) bei Betrieb vom als Sauggas strömenden Kältemittel kühlbar ist, und die thermisch leitende Verbindung der Kühlplatte (29) mit dem Frequenzumrichter/Inverter (33) lösbar durch reversible Demontage des Frequenzumrichter/Inverter (33) von der Kühlplatte (29) ausgebildet ist.

12. Heiz- und Klimaanlage (1) nach Anspruch 11, **dadurch gekennzeichnet, dass** zumindest ein Ventil (43, 45, 47) des wenigstens einen Ventils (43, 45, 47) gemäß Anspruch 3, 4, 9 oder 10 in die Kühlplatte (29) integriert oder an ihr direkt befestigt ist.

13. Heiz- und Klimaanlage (1) nach Anspruch 11 oder 12 **dadurch gekennzeichnet, dass** die Kühlplatte (29) mit dem Strömungsquerschnitt der durch sie oder an ihr verlaufenden Kältemittelleitung (31) für als Sauggas strömendes Kältemittel an den theoretischen maximalen Fördervolumenstrom des jeweiligen Verdichters (5) der Heiz- und Klimaanlage (1) angepasst oder anpassbar ist.

14. Heiz- und Klimaanlage (1) nach Anspruch 13 **dadurch gekennzeichnet, dass** der Strömungsquerschnitt der durch die oder an der Kühlplatte (29) verlaufenden Kältemittelleitung (31) für als Sauggas strömendes Kältemittel in mm² zwischen dem 10-fachen und 60-fachen, vorzugsweise dem 15-fachen, des theoretischen maximalen Fördervolumenstroms des Verdichters (5) in m³/h beträgt.

15. Kühlplatte (29) für eine Heiz- und Klimaanlage (1) nach einem der Ansprüche 11 bis 14.

16. Verfahren zum Regeln des Kühlens des Frequenzumrichters/Inverters (33) beim Betrieb einer Heiz- und Klimaanlage (1) nach einem der Ansprüche 1 bis 14, **dadurch gekennzeichnet, dass** abhängig von der Temperatur des Frequenzumrichters/Inverters (33) der Kältemittelkreislauf (3) für das Kühlen des Frequenzumrichters/Inverters (33) zu über 70 % der Wärmeableitung mittels als Sauggas strömenden Kältemittels geschaltet ist beziehungsweise wird oder für das Kühlen des Frequenzumrichters/Inverters (33) zu über 70 % der Wärmeableitung mittels Luft geschaltet ist beziehungsweise wird.

17. Verfahren nach Anspruch 16 **dadurch gekennzeichnet, dass** für das Kühlen des Frequenzumrichters/Inverters (33) mittels als Sauggas strömenden Kältemittels der Anteil vom Kältemittelstrom dafür in Abhängigkeit vom Kühlbedarf geregelt wird, wobei damit auch ein Schalten des Kühlens des Frequenzumrichters/Inverters (33) im Bereich von einschließlich 70 % bis zumindest herab bis einschließlich 30 % der Wärmeableitung mittels als Sauggas strömenden Kältemittels ermöglicht wird.

## Claims

1. Heating and air-conditioning system (1) for a vehicle, which system is designed to be operable for heating in the heat pump mode and, can be switched-over, for cooling in the air-conditioning mode, having a coolant circuit (3) comprising at least one electrically operable compressor (5), one external-air heat exchanger (7), one expansion member (9, 13) and one internal-air heat exchanger (11), designed in such a way that, in the air-conditioning mode, the external-air heat exchanger (7) can be operated as a condenser/gas cooler and the internal-air heat exchanger (11) can be operated as an evaporator and, in the heat pump mode, the external-air heat exchanger (7) can be operated as an evaporator and the internal-air heat exchanger (11) can be operated as a condenser/gas cooler, and the rotation speed of the compressor (5) can be regulated by means of a frequency converter/inverter (33), wherein the frequency converter/inverter (33) is arranged in such a way that it, in the case of at least one coolant line profile, in the air-conditioning mode, can be cooled to an extent of more than 70% of the heat dissipation from the frequency converter/inverter (33) by coolant, flowing as intake gas, in the coolant circuit (3) downstream of the internal-air heat exchanger (11) to the compressor (5) via a heat exchange connection, **characterized by** a coolant line profile which, in the heat pump mode, runs via at least one coolant line section, arranged for coolant flowing as intake gas, from the external-air heat exchanger (7) to the compressor (5) without a heat exchange connection to the frequency converter/inverter (33), and the frequency converter/inverter (33), in the heat pump mode, can be cooled to an extent of more than 70% of the heat dissipation from the frequency converter/inverter (33) with air.

2. Heating and air-conditioning system (1) according to Claim 1, **characterized in that**, in the case of at least one coolant line profile, in the heat pump mode, the frequency converter/inverter (33) can be cooled to an extent of 100% of the heat dissipation from the frequency converter/inverter (33) with air.

3. Heating and air-conditioning system (1) according to Claim 1 or 2, **characterized in that** it, in the air-conditioning mode, has a further coolant line profile, which can be switched by means of valves (43, 45, 47), downstream from the internal-air heat exchanger (11) to the compressor (5) without a heat exchange connection of coolant, flowing as intake gas, to the frequency converter/inverter (33).

4. Heating and air-conditioning system (1) according to one of Claims 1 to 3, **characterized in that** it also has a coolant line profile which can be switched by means of valves (43, 45, 47) and in which, in the heat pump mode, the frequency converter/inverter (33) can be cooled to an extent of more than 70% of the heat dissipation from the frequency converter/inverter (33) by coolant, flowing as intake gas, in the coolant circuit downstream from the external-air heat exchanger (7) to the compressor (5) via the heat exchange connection.

5. Heating and air-conditioning system (1) according to one of Claims 1 to 4, **characterized in that** it has a regulating arrangement (39) designed for switching the coolant circuit (3) between cooling the frequency converter/inverter (33) to an extent of more than 70% of the heat dissipation from the frequency converter/inverter (33) by means of coolant flowing as intake gas during operation and by means of air.

6. Heating and air-conditioning system (1) according to one of Claims 1 to 5, **characterized in that** a regulating arrangement (39) is designed in such a way that, for cooling the frequency converter/inverter (33) by means of coolant flowing as intake gas during operation, it can be used to regulate the proportion of coolant flow for said cooling.

7. Heating and air-conditioning system (1) according to Claim 5 or 6, **characterized in that** the regulating arrangement (39) is designed in such a way that the frequency converter/inverter (33) can also be regulated by it.

8. Heating and air-conditioning system (1) according to one of Claims 5 to 7, **characterized in that** the regulating arrangement (39) is designed in such a way that it can be used to adjust cooling of the frequency converter/inverter (33) to an extent of more than 70% of the heat dissipation from it by means of coolant flowing as intake gas during operation or to an extent of more than 70% of the heat dissipation from it by means of air, depending on a temperature, preferably on the temperature of the frequency converter/inverter (33), by switching the coolant circuit (3).

9. Heating and air-conditioning system (1) according to one of Claims 3 to 8, **characterized in that** it comprises at least one thermostatic valve (43) or at least one solenoid valve (47) for switching for the switchable further coolant line profile downstream from the internal-air heat exchanger (11) to the compressor (5) and/or for the switchable coolant line profile downstream from the external-air heat exchanger (7) to the compressor (5).

10. Heating and air-conditioning system (1) according to one of Claims 3 to 9, **characterized in that** at least one valve (43, 45, 47) for switching for the switchable coolant line profiles is/are designed as a controllable three-way valve (45) for adjusting for the flow path of the coolant between two of the coolant line profiles.

11. Heating and air-conditioning system (1) according to one of Claims 1 to 10, **characterized in that** a cooling plate (29) with a coolant line (31) running through it or on it is arranged in the coolant circuit (3) in a coolant line profile downstream from the internal-air heat exchanger (11), wherein the frequency converter/inverter (33) is thermally conductively connected to the cooling plate (29) in such a way that, via this heat exchange connection, the frequency converter/inverter (33) can be cooled by the coolant flowing as intake gas during operation, and the thermally conductive connection of the cooling plate (29) to the frequency converter/inverter (33) is designed in a releasable manner by reversible removal of the frequency converter/inverter (33) from the cooling plate (29).

12. Heating and air-conditioning system (1) according to Claim 11, **characterized in that** at least one valve (43, 45, 47) of the at least one valve (43, 45, 47) according to Claim 3, 4, 9 or 10 is integrated into the cooling plate (29) or is directly fastened to it.

13. Heating and air-conditioning system (1) according to Claim 11 or 12, **characterized in that** the cooling plate (29) is matched or can be matched to the theoretical maximum delivery volume flow of the respective compressor (5) of the heating and air-conditioning system (1) by way of the flow cross section of the coolant line (31), running through said cooling plate or on said cooling plate, for coolant flowing as intake gas.

14. Heating and air-conditioning system (1) according to Claim 13, **characterized in that** the flow cross section of the coolant line (31) running through the or on the cooling plate (29) for coolant flowing as intake gas in mm² is between 10 times and 60 times, preferably 15 times, the theoretical maximum delivery volume flow of the compressor (5) in m³/h.

15. Cooling plate (29) for a heating and air-conditioning system (1) according to one of Claims 11 to 14.

16. Method for regulating cooling of the frequency converter/inverter (33) during operation of a heating and air-conditioning system (1) according to one of Claims 1 to 14, **characterized in that** the coolant circuit (3) is or will be switched for cooling the frequency converter/inverter (33) to an extent of more than 70% of the heat dissipation by means of coolant flowing as intake gas or is or will be switched for cooling the frequency converter/inverter (33) to an extent of more than 70% of the heat dissipation by means of air, depending on the temperature of the frequency converter/inverter (33).

17. Method according to Claim 16, **characterized in that**, for cooling the frequency converter/inverter (33) by means of coolant flowing as intake gas, the proportion of coolant flow for this is regulated as a function of the cooling requirement, wherein switching of cooling of the frequency converter/inverter (33) in the range of from 70% inclusive down to at least 30% inclusive of the heat dissipation by means of coolant flowing as intake gas is thereby also rendered possible.

## Revendications

1. Installation de chauffage et de climatisation (1) pour un véhicule qui est conçue pour pouvoir être entraînée pour chauffer en mode de pompe à chaleur et pouvant être basculée pour refroidir en mode de climatisation, avec un circuit de moyen de refroidissement (3) comprenant au moins un compresseur (5) pouvant être actionné électriquement, un échangeur thermique d'air extérieur (7), un organe d'expansion (9, 13) et un échangeur thermique d'air intérieur (11), de telle sorte que dans le mode de climatisation, l'échangeur thermique d'air extérieur (7) puisse être entraîné sous la forme d'un condensateur/refroidisseur de gaz et que l'échangeur thermique d'air intérieur (11) puisse être entraîné sous la forme d'un évaporateur et que dans le mode de pompe à chaleur, l'échangeur thermique d'air extérieur (7) puisse être entraîné sous la forme d'un évaporateur et que l'échangeur thermique d'air intérieur (11) puisse être entraîné sous la forme d'un condensateur/refroidisseur de gaz et que le compresseur (5) puisse être réglé en terme de vitesse de rotation via un convertisseur de fréquence/inverseur (33) ;
le convertisseur de fréquence/inverseur (33) étant conçu de telle sorte qu'il peut être refroidi, en présence d'au moins un parcours de conduite de moyen de refroidissement dans le mode de climatisation, par le moyen de refroidissement s'écoulant sous la forme d'un gaz aspiré dans le circuit de moyen de refroidissement (3), en aval, depuis l'échangeur thermique d'air intérieur (11) jusqu'au compresseur (5), via une liaison d'échange thermique, pour jusqu'à plus de 70 % de l'évacuation de chaleur provenant du convertisseur de fréquence/inverseur (33) ;
**caractérisée par** un parcours de conduite de moyen de refroidissement s'étendant, dans le mode de pompe à chaleur, au-dessus d'au moins une section de conduite de moyen de refroidissement prévue pour le moyen de refroidissement s'écoulant sous la forme de gaz aspiré, depuis l'échangeur thermique d'air extérieur (7) jusqu'au compresseur (5), sans liaison d'échange thermique avec le convertisseur de fréquence/inverseur (33) et que le convertisseur de fréquence/inverseur (33) peut être refroidi avec de l'air dans le mode de pompe à chaleur pour jusqu'à plus de 70 % de l'évacuation de chaleur provenant du convertisseur de fréquence/inverseur (33).

2. Installation de chauffage et de climatisation (1) selon la revendication 1, **caractérisée en ce qu'**en cas d'au moins un parcours de conduite de moyen de refroidissement dans le mode de pompe à chaleur, le convertisseur de fréquence/inverseur (33) peut être refroidi avec de l'air pour jusqu'à 100 % de l'évacuation de chaleur provenant du convertisseur de fréquence/inverseur (33).

3. Installation de chauffage et de climatisation (1) selon la revendication 1 ou 2, **caractérisée en ce qu'**elle comporte, dans le mode de climatisation, un parcours de conduite de moyen de refroidissement supplémentaire pouvant être commuté par soupape (43, 45, 47), en aval, depuis l'échangeur thermique d'air intérieur (11) jusqu'au compresseur (5), sans liaison d'échange thermique de moyen de refroidissement s'écoulant sous la forme d'un gaz aspiré, avec le convertisseur de fréquence/inverseur (33).

4. Installation de chauffage et de climatisation (1) selon l'une quelconque des revendications 1 à 3, **caractérisée en ce qu'**elle comporte également un parcours de conduite de moyen de refroidissement pouvant être commuté par soupape (43, 45, 47) dans lequel, dans le mode de pompe à chaleur, le convertisseur de fréquence/inverseur (33) est refroidi par un moyen de refroidissement s'écoulant sous la forme d'un gaz aspiré dans le circuit de moyen de refroidissement en aval, depuis l'échangeur thermique d'air extérieur (7) jusqu'au compresseur (5), via la liaison d'échange thermique, pour jusqu'à plus de 70 % de l'évacuation de chaleur provenant du convertisseur de fréquence/inverseur (33).

5. Installation de chauffage et de climatisation (1) selon l'une quelconque des revendications 1 à 4, **caractérisée en ce qu'**elle comporte un réglage (39) réalisé pour connecter le circuit de moyen de refroidissement (3) entre le refroidissement du convertisseur de fréquence/inverseur (33) pour jusqu'à plus de 70 % de l'évacuation de chaleur provenant du convertisseur de fréquence/inverseur (33), à l'aide de moyen de refroidissement s'écoulant en fonctionnement sous la forme d'un gaz aspiré ou à l'aide d'air.

6. Installation de chauffage et de climatisation (1) selon l'une quelconque des revendications 1 à 5, **caractérisée en ce qu'**un réglage (39) est réalisé de telle sorte que pour le refroidissement du convertisseur de fréquence/inverseur (33) à l'aide du moyen de refroidissement s'écoulant en fonctionnement sous la forme d'un gaz aspiré, la partie de flux de moyen de refroidissement y étant consacrée est réglable.

7. Installation de chauffage et de climatisation (1) selon la revendication 5 ou 6, **caractérisée en ce que** le réglage (39) est réalisé de telle sorte que grâce à lui, le convertisseur de fréquence/inverseur (33) est également réglable.

8. Installation de chauffage et de climatisation (1) selon l'une quelconque des revendications 5 à 7, **caractérisée en ce que** le réglage (39) est réalisé de telle sorte que grâce à lui, le refroidissement du convertisseur de fréquence/inverseur (33) peut être réglable pour jusqu'à plus de 70 % de l'évacuation de chaleur provenant de lui en fonction d'une température, de préférence de la température du convertisseur de fréquence/inverseur (33), par connexion du circuit de moyen de refroidissement (3), à l'aide du moyen de refroidissement s'écoulant en fonctionnement sous la forme d'un gaz aspiré ou pour jusqu'à plus de 70 % de l'évacuation de chaleur provenant de lui à l'aide de l'air.

9. Installation de chauffage et de climatisation (1) selon l'une quelconque des revendications 3 à 8, **caractérisée en ce qu'**elle comprend pour la connexion pour le parcours de conduite de moyen de refroidissement supplémentaire, en aval, depuis l'échangeur thermique d'air intérieur (11) jusqu'au compresseur (5) et/ou pour le parcours de conduite de moyen de refroidissement connectable, en aval, depuis l'échangeur thermique d'air extérieur (7) jusqu'au compresseur (5), au moins une soupape thermostatique (43) ou au moins une électrovanne (47).

10. Installation de chauffage et de climatisation (1) selon l'une quelconque des revendications 3 à 9, **caractérisée en ce qu'**au moins une soupape (43, 45, 47) est conçue pour la commutation des parcours de conduite de moyen de refroidissement connectables, sous la forme d'une soupape à trois voies (45) réglable servant au réglage de la voie d'écoulement du moyen de refroidissement entre deux des parcours de conduite de moyen de refroidissement.

11. Installation de chauffage et de climatisation (1) selon l'une quelconque des revendications 1 à 10, **caractérisée en ce que** dans le circuit de moyen de refroidissement (3), dans un parcours de conduite de moyen de refroidissement en aval de l'échangeur thermique d'air intérieur (11), une plaque de refroidissement (29) est conçue avec une conduite de moyen de refroidissement (31) s'étendant à travers elle ou à son niveau, le convertisseur de fréquence/inverseur (33) pouvant être refroidi dans une liaison thermiquement conductrice menant à la plaque de refroidissement (29) de telle sorte que via cette liaison d'échange thermique, le convertisseur de fréquence/inverseur (33) puisse être refroidi en fonctionnement par le moyen de refroidissement s'écoulant sous la forme d'un gaz aspiré et que la liaison thermiquement conductrice de la plaque de refroidissement (29) avec le convertisseur de fréquence/inverseur (33) soit réalisée de façon amovible par démontage réversible du convertisseur de fréquence/inverseur (33) à partir de la plaque de refroidissement (29).

12. Installation de chauffage et de climatisation (1) selon la revendication 11, **caractérisée en ce qu'**au moins une soupape (43, 45, 47) de l'au moins une soupape (43, 45, 47) selon la revendication 3, 4, 9 ou 10 est fixée dans la plaque de refroidissement (29) de façon intégrée ou directement à son niveau.

13. Installation de chauffage et de climatisation (1) selon la revendication 11 ou 12, **caractérisée en ce que** la plaque de refroidissement (29) avec la section transversale d'écoulement de la conduite de moyen de refroidissement (31) s'étendant à travers elle ou à son niveau et prévue pour le moyen de refroidissement s'écoulant sous la forme d'un gaz aspiré est adaptée ou adaptable au volume d'extraction maximal théorique du compresseur (5) respectif de l'installation de chauffage et de climatisation (1).

14. Installation de chauffage et de climatisation (1) selon la revendication 13, **caractérisée en ce que** la section transversale d'écoulement de la conduite de moyen de refroidissement (31) s'étendant à travers la plaque de refroidissement (29) ou à son niveau et prévue pour le moyen de refroidissement s'écoulant sous la forme d'un gaz aspiré est, en mm², entre 10 fois et 60 fois, de préférence de 15 fois, le volume d'extraction maximal théorique du compresseur (5) en m³/h.

15. Plaque de refroidissement (29) pour une installation de chauffage et de climatisation (1) selon l'une quelconque des revendications 11 à 14.

16. Procédé de réglage du refroidissement du convertisseur de fréquence/inverseur (33) en situation de fonctionnement d'une installation de chauffage et de climatisation (1) selon l'une quelconque des revendications 1 à 14, **caractérisé en ce qu'**en fonction de la température du convertisseur de fréquence/inverseur (33), le circuit de moyen de refroidissement (3) prévu pour le refroidissement du convertisseur de fréquence/inverseur (33) est connecté pour plus de 70 % de l'évacuation de chaleur à l'aide du moyen de refroidissement s'écoulant sous la forme d'un gaz aspiré ou est connecté pour le refroidissement du convertisseur de fréquence/inverseur (33) pour plus de 70 % de l'évacuation de chaleur à l'aide d'air.

17. Procédé selon la revendication 16, **caractérisé en ce que** pour le refroidissement du convertisseur de fréquence/inverseur (33) à l'aide de moyen de refroidissement s'écoulant sous la forme d'un gaz aspiré, la partie respective du flux de moyen de refroidissement est réglée en fonction du besoin de refroidissement, une commutation du refroidissement du convertisseur de fréquence/inverseur (33) étant ainsi permise dans la plage de jusqu'à 70 % inclus et à partir de 30 % inclus de l'évacuation de chaleur à l'aide du moyen de refroidissement s'écoulant sous la forme d'un gaz aspiré.
